# EUROPEAN PATENT APPLICATION

(11) **EP 1 176 598 A2**
(43) Date of publication of application: **30.01.2002**
(21) Application number: 01117695.5
(22) Date of filing: 26.07.2001
(51) Int. Cl.: G11C 7/16

(54) **Digital recording and reproducing apparatus**

(30) Priority: 26.07.2000 JP 2000225210
(71) Applicant: TDK Corporation, Chuo-ku, Tokyo 103-8272 (JP)
(72) Inventor: Kobayashi, Nobuyuki, Chuo-ku, Tokyo 103-8272 (JP); Fujii, Ken, Chuo-ku, Tokyo 103-8272 (JP)
(74) Representative: VOSSIUS & PARTNER

(57) **Abstract**

A digital recording and reproducing apparatus(1) is provided which is capable of identifying a memory card(M) individually based on a relatively simple construction. An ID generation block(4) generates identification data DID for identifying the memory card(M) individually. An EEPROM(11) can store the identification data DID. A control block(10) records the identification data DID in the memory card(M) and the EEPROM(11), and carries out identification data determination processing for determining, when mounting of the memory card(M) is detected, whether or not the identification data DID recorded in the memory card(M) and the identification data DID recorded in the EEPROM(11) are identical to each other.

## Description

This invention relates to a digital recording and reproducing apparatus which is capable of recording and reproducing recorded data by using a removable external memory as a recording medium.

As a digital recording and reproducing apparatus of the above-mentioned kind, a sound recording and reproducing apparatus is known which uses a card-type removable memory (hereinafter referred to as the "memory card") as a recording medium. In this sound recording and reproducing apparatus, analog-to-digital conversion of an analog sound signal input through a microphone is carried out to generate sound data, and the sound data is caused to be recorded in the memory card. In this case, in a sound recording and reproducing apparatus of this kind, generally, when sound data has been recorded in a memory card, FAT (File Allocation Table) data of the sound data is recorded in a FAT data recording area of the memory card. On the other hand, when a sound is to be reproduced, sound data thereof is read out from the memory card in accordance with the FAT data, and then digital-to-analog conversion of the sound data is carried out to thereby generate an analog sound signal. This analog sound signal is sounded from a speaker or an earphone.

The above sound recording and reproducing apparatus, however, suffers from the following problems: In the sound recording and reproducing apparatus, when a sound is reproduced, sound data thereof is read out from a memory card according to FAT data which is read out from the memory card first. Therefore, for instance, if the memory card is forcibly removed from the apparatus without operating a stop button during a time period from the start of reproduction of the sound to the end thereof, and a memory card different from the above memory card is mounted, sound data-reading processing is started in an attempt to read out sound data from the different memory card mounted later, according to the to FAT data which was read out from the memory card mounted at a time point of the start of the reproduction of the sound. In this case, however, it is impossible to read out the sound data since the FAT data is different from FAT data read out from the memory card mounted later.

Further, normally, FAT data is recorded in a memory card when recording of sound data has been completed. Accordingly, for instance, if a memory card is forcibly removed from the apparatus without operating a stop button during a time period from the start of recording of sound data to the end thereof, and then a different memory card is mounted, the conventional sound recording and reproducing apparatus continues to record the sound data in the different memory card mounted later. Further, when recording of the sound data is stopped, FAT data corresponding to the sound data recorded in the memory card already removed from the apparatus as well as FAT data corresponding to the sound data recorded in the memory card mounted later are recorded in the FAT data recording area of the memory card mounted later. Therefore, in the conventional sound recording and reproducing apparatus, sound data and FAT data actually recorded conflict with each other, which makes it impossible to normally read out the sound data after recording thereof.

In the above case, if it is possible to determine whether or not a memory card mounted at the time point of the start of reproduction of a sound or at the time point of the start of recording sound data thereof is identical to a memory card mounted later, it becomes possible, for instance, to continue the reproduction or the recording when the memory cards are identical to each other and carry out predetermined error-handling processing when the memory cards are different from each other.

On the other hand, a digital sound recording and reproducing apparatus is disclosed in Japanese Laid-Open Patent Publication (Kokai) No. 7-200000, in which a user identification code, which is recorded in advance in a user identification code storage memory (internal memory) in the body of the apparatus, is recorded together with sound data in a sound cartridge (memory card), and when reproduction of the sound data is carried out, the user identification code is read out from the sound cartridge together with the sound data, and the identification code read out from the sound cartridge is compared with an identification code read out from the user identification code storage memory to thereby determine whether or not the sound cartridge is identical to a sound cartridge which was mounted at the time of recording of the sound data. In the above digital sound recording and reproducing apparatus, however, it is required to record beforehand in each apparatus one of user identification codes which are different from each other and formed such that they correspond to a vast number of apparatus bodies, respectively, and hence each user identification code itself becomes data complicated and large in size. Consequently, to record the user identification code, it is required to use a largecapacity memory as a user identification code storage memory, which results in increased manufacturing costs, and presents a problem that a data recordable area, which is valuable, of the sound cartridge is occupied by a large-sized data of a user identification code. Further, it take a long time period to carry out identification determination processing for identification of a complicated and large-sized user identification code, and at the same time a high-level determination program as well as a high performance control block are necessitated.

It is a main object of the invention to provide a digital recording and reproducing apparatus which is capable of identifying a memory card individually based on a relatively simple construction.

To attain the above object, the invention provides a digital recording and reproducing apparatus which is capable of having a removable external memory mounted therein, for performing recording of recording data in the external memory and reproduction based on the recording data recorded in the external memory, the digital recording and reproducing apparatus comprising an identification data-generating block for generating identification data for identifying the external memory individually, an internal memory in which the identification data can be recorded, and a control block for recording the identification data in the external memory and the internal memory, and carrying out identification data determination processing for determining, when mounting of the external memory is detected, whether or not the identification data recorded in the external memory and the identification data recorded in the internal memory are identical to each other.

The digital recording and reproducing apparatus according to the invention includes the identification data-generating block for generating identification data and the internal memory, and the control block thereof determines whether or not the identification data recorded both in the external memory and the internal memory are identical to each other, whereby, for instance, when the external memory is removed and remounted during of reproduction of the recording data recorded in the external memory, the digital recording and reproducing apparatus is capable of reliably and easily determining whether or not the external memory mounted again is the external memory which had been mounted when the recording data started to be reproduced although the apparatus is simple in construction. Therefore, it is possible to read out the recorded recording data continuously from the same external memory. Further, differently from a method in which identification data is fixedly recorded in advance in an external memory, the manufacturing costs of the external memory itself can be reduced, thereby making it possible to employ the inexpensive external memory as a recording medium.

It is preferred that the control block records the identification data in both of the external memory and the internal memory before the recording data is recorded in the external memory.

According to this preferred embodiment, the control block records the identification data in both of the memories before the recording data is recorded in the external memory, whereby even if the memory card is forcibly removed during recording of the recorded data in the external memory, it is possible to reliably determine whether or not the identification data recorded in the internal memory and that recorded in the external memory are identical to each other. This makes it possible to reliably and easily determine whether or not the mounted external memory is the external memory which had been mounted when recording of the recording data was started. This enables the recording data to be recorded continuously in the same external memory.

It is preferred that the control block carries out the identification data determination processing when the external memory is removed and mounted during recording of the recording data in the external memory, the control block continuing to record the recording data in the mounted external memory when the identification data recorded in the external memory and the identification data recorded in the internal memory are identical to each other, and carrying out predetermined error-handling processing when the identification data recorded in the external memory and the identification data recorded in the internal memory are different from each other.

According to this preferred embodiment, the control block carries out the identification data determination processing when the external memory is removed and mounted again during recording of the recorded data in the external memory, and selectively executes the recording of the recording data in the external memory or the predetermined error-handling processing according to a result of the determination processing. Accordingly, if the same external memory is mounted, the recording of the recorded data can be continued, whereas if a different memory is mounted, it is possible to notify the operator of the fact e.g. by displaying an error message or making a warning sound.

It is preferred that the control block causes the recording data to be recorded in the internal memory when the external memory is removed during recording of the recording data in the external memory, carries out the identification data determination processing when the external memory is mounted, and records the recording data recorded in the internal memory, in the mounted external memory when the identification data recorded in the external memory and the identification data recorded in the internal memory are identical to each other.

According to this preferred embodiment, the control block causes the recording data to be recorded in the internal memory when the external memory is removed during recording of the recording data in the external memory, carries out the identification data determination processing when the external memory is mounted, and records the recording data recorded in the internal memory, in the mounted external memory when the identification data recorded in both of the internal and external memories are identical to each other. This makes it possible to record the recording data without losing any part thereof.

It is preferred that the identification data-generating block generates numerical value information at random to thereby generate the identification data.

According to this preferred embodiment, the identification data-generating block is provided which generates numerical value information at random, as the identification data, whereby it is possible to provide a digital recording and reproducing apparatus which, when compared with a method of using intricately encrypted data as identification data, is capable of shortening time periods required for respective processes carried out based on the identification data, for generating identification data and for determining identity of the mounted external memory, as well as reliably determining the identity of the external memory although the apparatus is relatively simple in construction.

It is preferred that the recording data is sound data, and that the digital recording and reproducing apparatus includes a sound signal input block for inputting an analog sound signal, a sound data generation block for generating the sound data by converting the analog sound signal to digital data and compressing the digital data, a sound signal generation block for decompressing the sound data recorded in the external memory to generate the digital data and converting the digital data to the analog sound signal, and an amplifier circuit for amplifying the converted analog sound signal to output the amplified sound signal.

According to this preferred embodiment, by the digital recording and reproducing apparatus according to the invention to a voice recorder which records sound data (voice data) continuously and over a long time period and whose external memory is liable to be removed erroneously, such that sound data can be recorded and reproduced, it is possible to determine the identity of the external memory reliably and easily when the external memory is removed and remounted.
This makes it possible to continually read out the sound data from the same external memory and record the sound data in the same external memory.

It should be noted that the disclosure of the present specification relates to the subjects included in Japanese Patent Application No. 2000-225210 which was filed with Japanese Patent Office on July 26, 2000, and all of the disclosures thereby are expressly incorporated herein by reference.

These and other objects and features of the present invention will be explained in more detail below with reference to the attached drawings, wherein:
FIG. 1 is a block diagram showing the arrangement of a sound recording and reproducing apparatus according to an embodiment of the invention;
FIG. 2 is an area map showing an example of a recording area in a memory card M mounted in the sound recording and reproducing apparatus;
FIG. 3 is a configuration map showing an example of a format of sound data Ds;
FIG. 4 is an area map showing another example of a recording area in an EEPROM for the sound recording and reproducing apparatus 1;
FIG. 5 is a flowchart showing a main routine executed by the sound recording and reproducing apparatus;
FIG. 6 is a flowchart showing a recording process executed by the sound recording and reproducing apparatus;
FIG. 7 is a flowchart showing a reproduction process executed by the sound recording and reproducing apparatus; and
FIG. 8 is a flowchart showing another recording process executed by the sound recording and reproducing apparatus.

The invention will now be described in detail with reference to drawings showing a preferred embodiment thereof. In this embodiment, a digital recording and reproducing apparatus according to the invention is applied to a sound recording and reproducing apparatus 1.

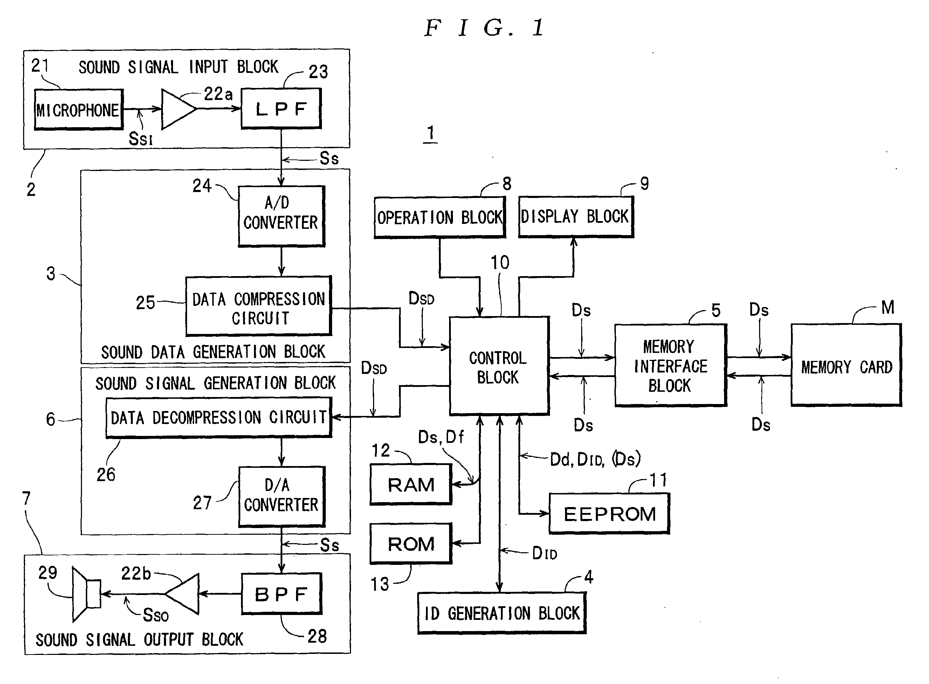

First, the arrangement of the sound recording and reproducing apparatus 1 will be described with reference to FIG. 1 et. seq.

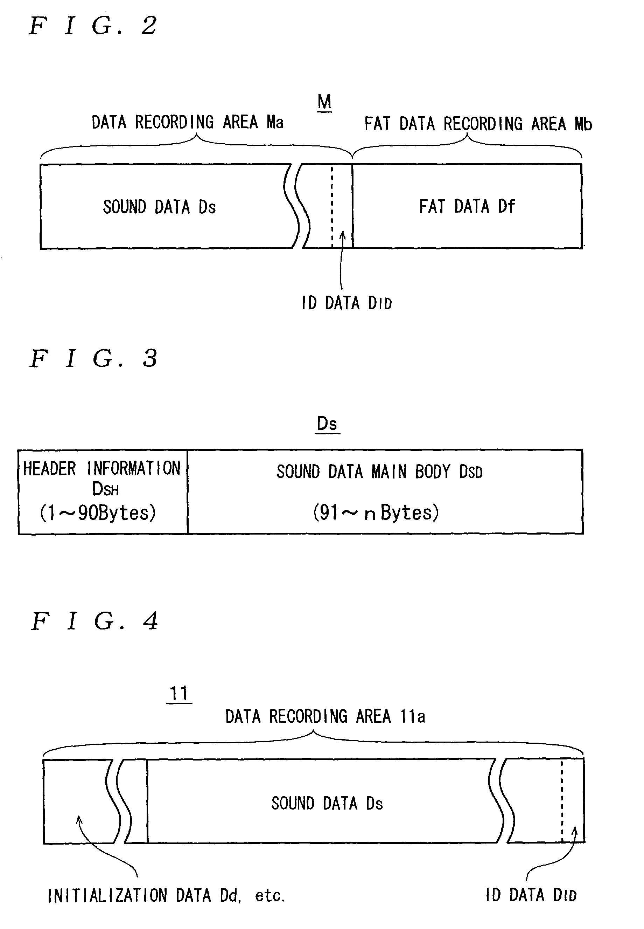

Referring to FIG. 1, the sound recording and reproducing apparatus 1 is a portable voice recorder which is configured to be capable of having a memory card M as a recording medium mounted therein, and performs not only recording of sound data (voice data) formed by converting an analog sound signal into digital data, but also reproduction of an analog sound signal formed by converting sound data (voice data) recorded in the memory card M into analog data. The memory card M of this embodiment corresponds to an external memory of the invention, and is implemented by an existing card-type removable memory in which a semiconductor device is sealed by a resin, for recording ID data DID for identification of the memory card M, sound data Ds, and so forth. Further, as shown in FIG. 2, the recording area of the memory card M is divided into a data recording area Ma for recording the sound data Ds and the ID data DID, and a FAT data recording area Mb for recording FAT data Df of the data recorded in the data recording area Ma. On the other hand, as shown in FIG. 1, the sound recording and reproducing apparatus 1 includes a sound signal input block 2, a sound data generation block 3, an ID generation block 4, a memory interface block 5, a sound signal generation block 6, a sound signal output block 7, an operation block 8, a display block 9, a control block 10, an EEPROM 11, a RAM 12, and ROM 13.

The sound signal input block 2 is comprised of a microphone 21 for collecting sounds to output an analog sound signal SSI, an amplifier 22a for amplifying the input analog sound signal SSI to output the resulting signal, and an LPF 23 for subjecting the amplified analog sound signal SSI to low-pass filtration to thereby pass an analog sound signal Ss therethrough.

The sound data generation block 3 includes an A/D converter 24 for converting the analog sound signal Ss to digital data, and a data compression circuit 25 for compressing the digital data into a sound data main body DSD. It should be noted that the sound data main body DSD corresponds to sound data of the present invention. The ID generation block 4 corresponds to an identification data-generating block of the present invention, which generates numerical value information of e.g. 8 bits (256 kinds) at random under the control of the control block 10, as ID data DID. The memory interface block 5 includes a connector capable of having the memory card M mounted therein, and executes recording of the sound data Ds in the memory card M under the control of the control block 10, and reading of the sound data Ds from the memory card M. The sound signal generation block 6 includes a data decompression circuit 26 for decompressing the sound data main body DSD to decode the same into digital data, and a D/A converter 27 for converting the digital data into the analog sound signal Ss. The sound signal output block 7 includes a BPF 28 for filtering the analog sound signal Ss at a predetermined frequency band to generate an analog sound signal, an amplifier 22b for amplifying the analog sound signal output from the BPF 28 to output an analog sound signal SSO, and a speaker 29 for sounding tones based on the analog sound signal SSO. Further, the sound recording and reproducing apparatus 1 has an earphone jack, not shown, arranged therein, and when an earphone is connected to the earphone jack, tones are sounded based on the analog sound signal SSO from the earphone in place of the speaker 29.

On the operation block 8, there are arranged a plurality of operation buttons, such as a record button, a playback button, a fast forward button, a rewind button, a stop button, a menu button, a power button, and the like. The display block 9 is formed by an LCD panel for displaying the remaining recordable capacity of the memory card M, time elapsed from the start of recording/playback (reproduction) of a sound, and the remaining capacity of a battery, not shown, and so forth. The control block 10 is implemented e.g. by a 16-bit CPU, and carries out control of the sound signal input block 2, the sound data generation block 3, the ID generation block 4, the sound signal generation block 6, and the sound signal output block 7, in response to operations of the buttons of the operation block 8, and control of recording of the sound data Ds in the memory card M via the memory interface block 5, and reading of the sound data Ds from memory card M. The EEPROM 11 corresponds to an internal memory of the present invention and stores the initialization data Dd of the sound recording and reproducing apparatus 1, the ID data DID generated by the ID generation block 4, and so forth. The RAM 12 temporarily stores the FAT data Df of the sound data Ds which is being recorded in the memory card M, results of calculation carried out by the control block 10, etc. Further, the ROM 13 stores an operation program executed by the control block 10.

Next, the overall operation of the sound recording and reproducing apparatus 1 will be described in detail with reference to drawings.

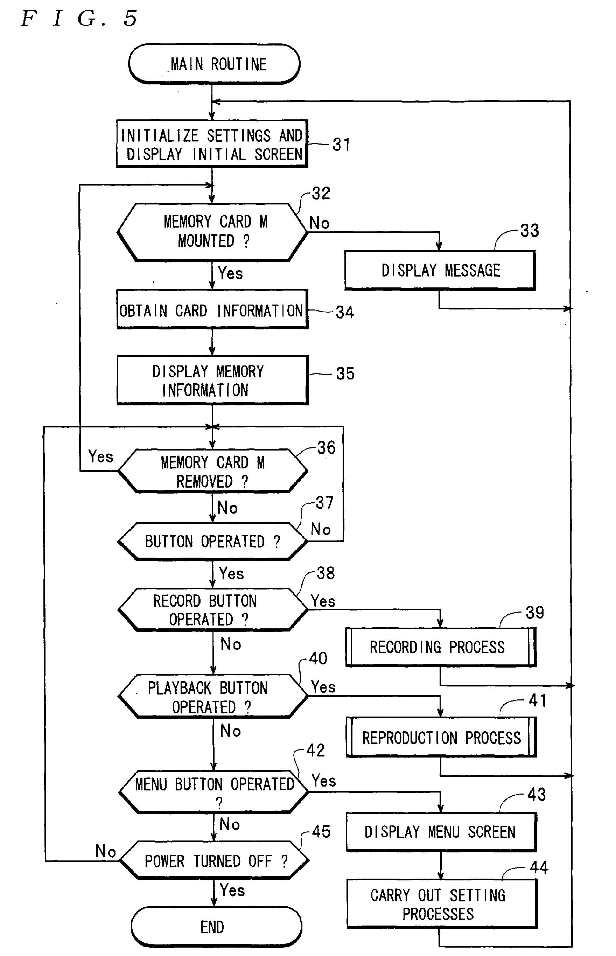

First, the basic operation carried out by the sound recording and reproducing apparatus 1 will be described with reference to FIG. 5. As shown in the figure, in the sound recording and reproducing apparatus 1, when a power switch is turned on, a main routine is started whereby the control block 10 reads out the initialization data Dd from the EEPROM 11, and after initialization of each circuit, causes the display block 9 to display an initial screen, not shown, at a step S31. Next, the control block 10 determines at a step S32 whether or not a memory card M is mounted in the memory interface block 5. At this time, if the control block 10 determines that there is no memory card M mounted in the memory interface block 5, it causes the display block 9 to display a message e.g. of "NO MEMORY CARD IS MOUNTED" at a step S33. On the other hand, if the control block 10 determines that a memory card M is mounted, the control block 10 obtains card information, such as attribute data of the sound data Ds already recorded in the memory card M, the recordable capacity and remaining recordable capacity of the memory card M, and the like, from the memory card M to cause the RAM 12 to store the card information at a step S34. Then, the control block 10 causes the display block 9 to display memory information, such as a recordable time period which is calculated based on the remaining recordable capacity included in the obtained card information, at a step S35.

Thereafter, the control block 10 monitors at a step S36 whether or not the memory card M has been removed from the memory interface block 5. If the control block 10 detects that the memory card M has been removed, it determines again at the step S32 whether or not a memory card M is mounted in the memory interface block 5, whereas if the memory card M is mounted, the control block 10 monitors button operations in the operation block 8 at a step S37. When a button operation was detected, the control block 10 determines at a step S38 whether or not the operated button was the record button. If the record button was operated, the control block 10 carries out a recording process, described hereinafter, at a step S39, to record the sound data Ds in the memory card M, and then causes the display block 9 to display the initial screen again at the step S31. On the other hand, if the operated button was not the record button, it is determined at a step S40 whether or not the operated button was the playback button. If the playback button was operated, the control block 10 carries out a reproduction process, described hereinafter, at a step S41, to read out the sound data Ds from the memory card M and reproduce the sound, and then causes the display block 9 to display the initial screen again at the step S31.

If the operated button was not the playback button, it is determined at a step S42 whether or not the operated button was the menu button. If the menu button was operated, the control block 10 causes the display block 9 to display a menu screen for use in selecting a setting screen for setting the operating conditions of the sound recording and reproducing apparatus 1 and a function screen for using auxiliary functions, at a step S43, and carries out various setting processes e.g. for setting the operating conditions of the apparatus 1 in response to button operations in the operation block 8 at a step S44. On the other hand, if the menu button was not operated, it is determined at a step S45 whether or the operated button was the power button. When the power button was operated, the control block 10 deletes the display screen of the display block 9 and cuts off the power supply.

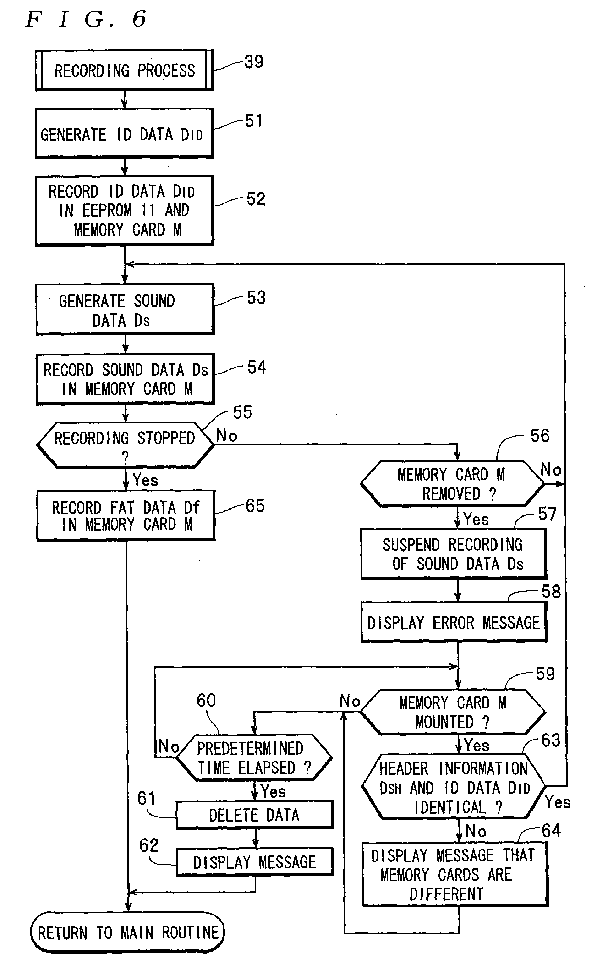

Next, the above-mentioned recording process (step S39) will be described with reference to FIGS. 3 and 6. In this process, first, the ID generation block 4 generates ID data DID under the control of the control block 10 at a step S51. Then, the control block 10 records the generated ID data DID in a data recording area in the EEPROM 11, e.g. in the final recording area thereof, and in a data recording area Ma in the memory card M, e.g. in the final recording area thereof, at a step S52. Then, the control block 10 generates sound data Ds based on the sound data main body DSD input via the sound signal input block 2 and the sound data generation block 3, at a step S53. More specifically, the amplifier 22a amplifies the analog sound signal SSI input through the microphone 21, and the LPF 23 filters the analog sound signal SSI to output an analog sound signal Ss. Next, the A/D converter 24 converts the analog sound signal Ss to digital data, and the data compression circuit 25 compresses the digital data to generate a sound data main body DSD. Thereafter, the control block 10 adds header information DSH, such as the title of a recorded file and the recording date of the file, to the sound data main body DSD, to thereby generate sound data Ds. Next, the control block 10 causes the sound data Ds to be temporarily stored in the RAM 12. In the above process, at the time point the recording operation is started, as shown in FIG. 3, the control block 10 adds the header information DSH concerning the sound data main body DSD to the 1-st to 90-th bytes of the sound data Ds, and adds the sound data main body DSD to the 91-th and subsequent bytes of the sound data Ds to thereby store the sound data Ds in the RAM 12.

From this time on, the control block 10 continues to generate the sound data Ds until the stop button is operated. In the meanwhile, the control block 10 reads out the sound data Ds from the RAM 12, and sequentially records the same in the data recording area Ma of the memory card M via the memory interface block 5 at a step S54. At this time, the control block 10 sequentially records the FAT data Df concerning the sound data Ds recorded in the memory card M, in the recording area of the RAM 12. While recording the sound data Ds, the control block 10 determines at a step S55 whether or not the recording operation was stopped by operating the stop button. If the recording operation was not stopped, the control block 10 determines at a step S56 whether or not the memory card M has been removed from the memory interface block 5. If the memory card M has not been removed, the control block 10 repeatedly carries out the step S53 for generating the sound data Ds and the step S54 for recording the sound data Ds in the memory card M, thereby sequentially recording the sound data Ds corresponding to a sound collected by the microphone 21 in the data recording area Ma of the memory card M.

On the other hand, if it is determined at the step S56 that the memory card has been removed, the control block 10 suspends recording of the sound data Ds at a step S57, and causes the display block 9 to display an error message e.g. of "MEMORY CARD IS REMOVED. MOUNT MEMORY CARD" at a step S58.

Next, the control block 10 monitors at a step S59 whether or not a memory card M has been mounted in the memory interface block 5. If there is no memory card M mounted, the control block 10 determines at a step S60 whether or not a predetermined time period (30 minutes, for instance) has elapsed after removal of the memory card M. If the predetermined time period has elapsed, it is considered that the operator does not intend to continue to record the sound data Ds, so that the control block 10 deletes the sound data Ds and FAT data Df recorded in the RAM 12 at a step S61, and causes the display block 9 to display a message to the effect that the recording operation cannot be continued, at a step S62. Then, the program returns to the main routine, and the control block 10 causes the display block 9 to display the initial screen at the step S31.

On the other hand, when it is determined at the step S59 that a memory card M has been mounted, the control block 10 determines whether or not the mounted memory card M is identical to the memory card M which had been mounted at the time point of the start of recording of the sound data Ds. More specifically, first, the control block 10 reads out the header information DSH of the sound data Ds, which is recorded in the RAM 12, and the header information DSH of the sound data Ds, which is recorded in the memory card M, for comparison with each other, whereby the control block 10 determines at a step S63 whether or not the attributes of the files of these sound data Ds are identical to each other. At this time, when the above file attributes are different from each other, at a step S64, the control block 10 determines that the mounted memory card M is different from the memory card M which had been mounted at the time point of the start of the recording operation, and causes the display block 9 to display a message to the effect that a different memory card M has been mounted. In this state, the control block 10 repeatedly determines at the step S59 whether or not a memory card M has been mounted, until it is determined at the step S60 that the predetermined time period has elapsed.

On the other hand, when it is determined at the step S63 that the file attributes are identical to each other, the control block 10 reads out the ID data DID recorded in the EEPROM 11 and the ID data DID recorded in the mounted memory card M, and determines at the step S63 whether or not the these ID data DID are identical to each other. If the ID data DID recorded in the EEPROM 11 is different from the ID data DID recorded in the mounted memory card M, the control block 10 determines at the step S63 that the mounted memory card M is different from the memory card M which had been mounted at the time point of the start of the recording operation, and causes the display block 9 to display the message to the effect that a different memory card M has been mounted. Then, the control block 10 repeatedly determines at the step S59 whether or not a memory card M has been mounted, until it is determined at the step S60 that the predetermined time period has elapsed. Meanwhile, if the ID data DID recorded in the EEPROM 11 is identical to the ID data DID recorded in the mounted memory card M, the control block 10 generates sound data Ds at the step S53, and resumes recording of the sound data Ds in the mounted memory card M at the step S54. Thereafter, when the stop button is operated at the step S55, the control block 10 records the FAT data Df temporarily recorded in the recording area of the RAM 12 in the FAT data recording area Mb of the memory card M at a step S65. The recording process is thus completed at the step S65 to repeatedly carry out the main routine at the step S31.

As described hereinabove, according to the sound recording and reproducing apparatus 1, the ID data DID generated by the ID generation block 4 is recorded in both the EEPROM 11 and the memory card M before the sound data Ds is recorded in the memory card M, whereby even when the memory card M has been forcibly removed from the memory interface block 5 without operating the stop button, it is possible to determine with accuracy whether or not a memory card M mounted again is identical to the memory card M which had been mounted when the sound data Ds started to be recorded. Therefore, when the above memory cards M are identical to each other, it is possible to continue to record the sound data Ds in the newly mounted memory card M. Further, when it is determined whether or not the memory cards M are identical to each other, the header information DSH of the sound data Ds recorded in the RAM 12 and the header information DSH of the sound data Ds recorded in the memory card M are compared with each other before comparison between the ID data DID recorded in the EEPROM 11 and the ID data DID recorded the mounted memory card M, whereby it is possible to determine more reliably whether or not the memory cards M are identical to each other.

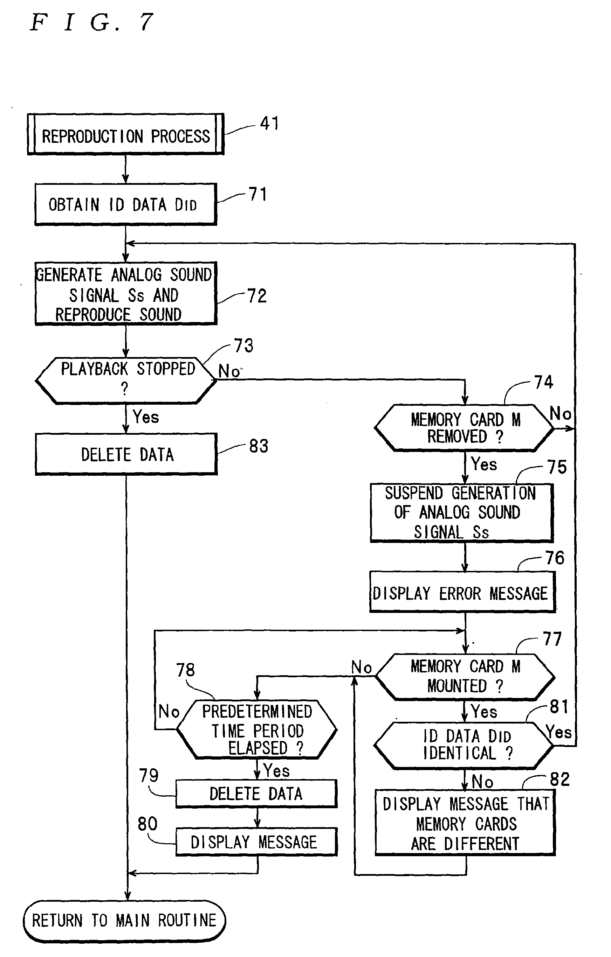

Next, the above-mentioned reproduction process (step S41) will be described with reference to FIG. 7. In this process, first, the control block 10 reads out the ID data DID from the mounted memory card M to temporarily store the same in the RAM 12 at a step S71. Then, an analog sound signal Ss is generated and a sound is reproduced at a step S72. More specifically, the control block 10 reads out the sound data Ds from the memory card M, and transfers the sound data main body DSD which is formed by removing the header information DSH from the sound data Ds to the data decompression circuit 26. Next, the data decompression circuit 26 decompresses the sound data main body DSD to generate digital data, which is converted by the D/A converter 27 to the analog sound signal Ss. Then, the BPF 28 filters the analog sound signal Ss, the amplifier 22b amplifies the filtered analog sound signal Ss to generate an analog sound signal SSO, which is sounded from the speaker 29. Thus, a sound is reproduced based on the sound data Ds.

In this process, the control block 10 determines at a step S73 whether or not the reproduction process is stopped by operating the stop button during reproduction of the sound. If the reproduction process is not stopped, the control block 10 determines at a step S74 whether or not the memory card M has been removed from the memory interface block 5. If the memory card M remains mounted in the memory interface block 5, reproduction of the sound continues at the step S72, whereas if the memory card M has been removed due to wrong operations or the like, the control block 10 causes the sound signal generation block 6 to suspend generation of the analog sound signal Ss at a step S75, and at the same time causes the display block 9 to display an error message e.g. of "MEMORY CARD IS REMOVED. MOUNT MEMORY CARD" at a step S76.

Then, the control block 10 determines at a step S77 whether or not a memory card M has been mounted. If there is no memory card M mounted, the control block 10 determines at a step S78 whether or not a predetermined time period (e.g. 30 minutes) has elapsed after removal of the memory card M. If the predetermined time period has elapsed, it is considered that the operator does not intend to continue to reproduce the sound data Ds, so that the control block 10 deletes the ID data DID read in the RAM 12 at a step S79, and causes the display block 9 to display a message to the effect that the playback operation cannot be continued, at a step S80. Then, the program returns to the main routine, and the control block 10 causes the display block 9 to display the initial screen at the step S31.

Further, when it is determined at the step S77 that a memory card M has been mounted, the control block 10 determines whether or not the mounted memory card M is identical to the memory card M which had been mounted when the reproduction of the sound data Ds started. More specifically, first, the control block 10 reads out the ID data DID recorded in the RAM 12 and the ID data DID recorded in the data recording area Ma of the memory card M mounted in the memory interface block 5, and determines at a step S81 whether or not the ID data DID recorded in the RAM 12 is identical to the ID data DID recorded in the data recording area Ma of the memory card M. If the ID data DID recorded in the RAM 12 is different from the ID data DID recorded in the data recording area Ma, the control block 10 determines that the mounted memory card M is different from the memory card M which had been mounted when the reproduction of the sound data Ds started, and at a step S82, causes the display block 9 to display a message to the effect that a different memory card M has been mounted. The control block 10 repeatedly determines at the step S77 whether or not a memory card M has been mounted, until it is determined at the step S78 that the predetermined time period has elapsed. On the other hand, if the ID data DID recorded in the RAM 12 is identical to the ID data DID recorded in the data recording area Ma of the memory card M, the control block 10 reads out the sound data Ds from the memory card M, and causes the sound signal generation block 6 to resume generation of the analog sound signal Ss at the step S72. Thereafter, when the stop button is operated to stop the reproduction at the step S73, the control block 10 deletes the ID data DID recorded in the RAM 12 at a step S83. The reproduction process is thus completed, and the main routine is repeatedly carried out at the step S31.

As described hereinabove, according to the sound recording and reproducing apparatus 1, the ID data DID generated by the ID generation block 4 is recorded in the memory card M when the sound data Ds is recorded in the memory card M, whereby when the sound is reproduced, even if the memory card M has been forcibly removed from the memory interface block 5 without operating the stop button, it is possible to determine with accuracy whether or not a newly mounted memory card M is identical to the memory card M which had been mounted at the start of the reproduction of the sound data Ds. Therefore, when the above memory cards M are identical to each other, it is possible to continue reproduction of the sound based on the sound data Ds recorded in the newly mounted memory card M.

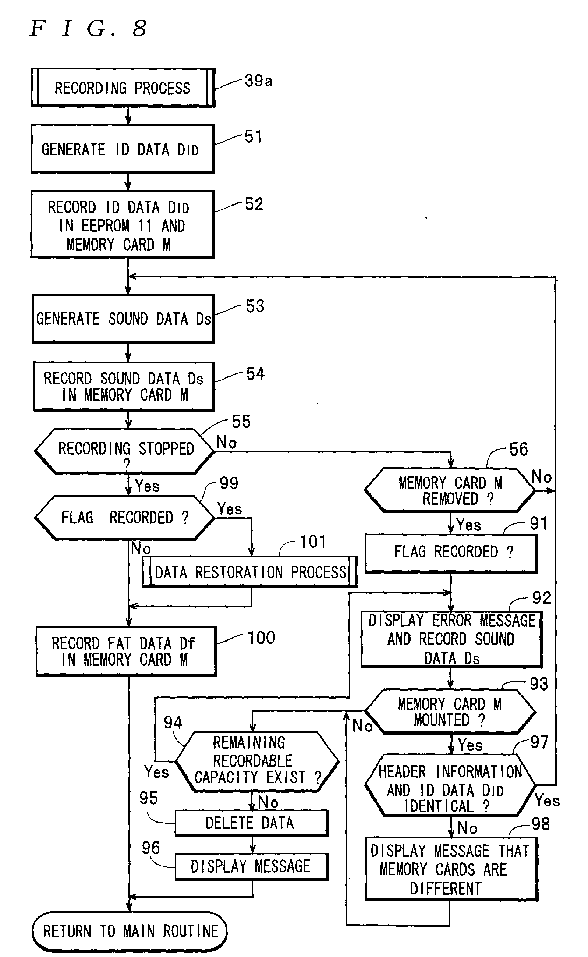

Next, a recording process (step S39a) which is carried out by another method in place of the above recording process (step S39) will be described with reference to FIGS. 4 and 8. In this recording process, when the control block 10 detects operation of the record button, similarly to the step S51 to S55 of the recording process described above, the control block 10 causes the ID data DID to be recorded in the memory card M and the EEPROM 11, and then causes the sound data Ds to be recorded in the memory card M. Meanwhile, when this recording process is employed, as shown in FIG. 4, the data recording area 11a of the EEPROM 11 is divided beforehand into a recording area for recording the initialization data Dd, a backup area for the sound data Ds, and a recording area for recording the ID data DID. Further, the ID data DID is recorded in the final recording area of the data recording area 11a, similarly to the case of the above-mentioned recording process.

In the present recording process, the control block 10 determines at the step S56 whether or not the memory card M has been removed from the memory interface block 5. If the memory card M has been removed, a flag indicative of the fact is recorded e.g. in a leading-end recording area of the backup area of the EEPROM 11 for the sound data Ds. Next, the control block 10 causes the display block 9 to display an error message e.g. of "MEMORY CARD IS REMOVED. MOUNT MEMORY CARD", and records generated sound data Ds in the data recording area 11a of the EEPROM 11, at a step S92. Then, the control block 10 determines at a step S93 whether or not a memory card M has been mounted. If there is no memory card M mounted, the control block 10 determines at a step S94 whether or not the backup area of the data recording area 11a has a remaining recordable capacity. If the backup area of the data recording area 11a has a remaining recordable capacity, the control block 10 causes the display block 9 to display the error message, and records generated sound data Ds in the backup area at the step S92. On the other hand, if it is determined at the step S94 that the backup area of the data recording area 11a does not have any remaining recordable capacity, the control block 10 deletes the sound data Ds and FAT data Df recorded in the RAM 12 as well as the sound data Ds recorded in the backup area of the EEPROM 11 at a step S95, and causes the display block 9 to display a message to the effect that the recording process cannot be continued at a step S96. Thereafter, the program returns to the main routine to cause the display block 9 to display the initial screen at the step S31.

Meanwhile, if it is determined at the step S93 that a memory card M has been mounted, similarly to the step S81 in the above-mentioned recording process (step S41), the control block 10 determines at a step S97 whether or not the header information DSH recorded in the mounted memory card M is identical to the header information DSH recorded the RAM 12 and the ID data DID recorded in the mounted memory card M is identical to the ID data DID recorded in the RAM 12, whereby the control block 10 determines whether or not the mounted memory card M is identical to the memory card M which had been mounted when the sound data Ds started to be recorded. When at least either of the header information items DSH or the ID data items DID are different from each other, the control block 10 causes the display block 9 to display a message to the effect that a different memory card M has been mounted, at a step S98. Then, so long as it is determined at the step S94 that the backup area has a remaining recordable capacity, the control block 10 causes the display block 9 to display the error message, and records the generated sound data Ds in the backup area at the step S92. On the other hand, if both of the respective header information items DSH and the respective ID data items DID are identical to each other, the control block 10 generates sound data Ds at the step S53, and resumes recording of the sound data Ds in the mounted memory card M at the step S54. Thereafter, when the stop button is operated to stop the recording operation at the step S55, the control block 10 determines at a step S99 whether or not the flag indicating that the memory card M has been removed is recorded in the EEPROM 11. At this time, if the flag is not recorded in the EEPROM 11, the control block 10 causes the FAT data Df temporarily recorded in the RAM 12 to be recorded in the FAT data recording area Mb of the memory card M at a step S100. The recording process is thus completed, and the main routine is repeatedly carried out at the step S31.

On the other hand, if it is determined at the step S99 that the flag is recorded, the control block 10 transfers the sound data Ds recorded in the backup area of the EEPROM 11 to the memory card M to thereby restore the sound data Ds in the memory card M without losing any part thereof at a step S101. Then, the control block 10 causes the FAT data Df temporarily recorded in the RAM 12 to be recorded in the FAT data recording area Mb of the memory card M at the step S100. The recording process is thus completed, and the main routine is repeatedly carried out at the step S31.

As described hereinabove, according to the sound recording and reproducing apparatus 1, even when the memory card M has been forcibly removed from the memory interface block 5 without operating the stop button, it is possible to determine with accuracy whether or not a newly mounted memory card M is identical to the memory card M which had been mounted when the sound data Ds started to be recorded. Hence, when the same memory card M is remounted, by transferring the sound data Ds preserved in the backup area of the EEPROM 11 to the memory card M, it is also possible to restore the sound data Ds without losing any part thereof. Therefore, the record of the sound data Ds is not lost even if the memory card M is removed during recording of the sound data Ds, so that the sound can be properly reproduced based on the sound data Ds.

It should be noted that the present invention is not limited to the above embodiments, but the construction thereof can be modified as required. For instance, although in the embodiments of the invention, description was given based on the example in which the ID data DID is recorded in the memory card M and the EEPROM 11 immediately after the record button is operated, this is not limitative, but the ID data DID may be recorded in the memory card M and the EEPROM 11 when the sound data Ds has been recorded in the memory card M. In this case as well, in a state in which the sound data Ds has been normally recorded, even if the memory card M is forcibly removed and the same or different card M is mounted again during reproduction of the sound based on the sound data Ds, it is possible to determine whether or not the memory card M which had been mounted when the sound data Ds started to be reproduced and the memory card M which is mounted again in the memory interface block 5 at the present time point are identical to each other.

Although in the embodiments of the invention, description was given based on the example in which numerical value information of eight bits generated at random is recorded as ID data DID, this is not limitative, but identification data of 4 to 32 bits can be employed as the ID data DID. In this case, in the sound recording and reproducing apparatus 1 configured assuming that a plurality of memory cards M are selectively used, it is preferable to use ID data DID formed of 4 or more bits so as to enable the memory cards M to be identified individually. Further, ID data DID of 32 bits or more takes somewhat longer time for generation and identification of the ID data, and such ID data DID becomes complicated, accordingly complicating an identification program. Therefore, it is preferable to use ID data DID of 4 to 16 bits. Further, if ID data DID is generated depending on the processing capability of a CPU implementing the control block, such that e.g. when an 8 bit CPU is used, ID data DID of 8 bits or less is generated, and when a 16 bit CPU is used, ID data DID of 16 bits or less is generated, it becomes possible to carry out high-speed identification processing based on the ID data DID.

Further, although in the embodiments of the invention, the example of recording the sound data Ds was described, this is not limitative, but it goes without saying that recorded data in the present invention may be various digital data, including video data, numerical value data, text data, etc. Further, the sound data Ds employed in the present invention includes not only the sound data Ds which is generated by the analog-to-digital conversion of an analog sound signal Ss collected by the microphone 21 but also sound data which is generated based on a sound signal input via a sound signal input terminal, sound data which is obtained through a communication terminal, and the like. Furthermore, the external memory in the present invention includes not only the memory card, but also various other removable memories, such as bar-like and chip-like memories, and a disk-shaped digital data recording medium. Further, as the internal memory of the present invention, there can be used not only the EEPROM 11 but also various kinds of writable and readable memories, such as a RAM and the like. In addition, it is also possible to use separate internal memories independently of each other for recording identification data and recorded data, respectively.

## Claims

1. A digital recording and reproducing apparatus which is capable of having a removable external memory mounted therein, for performing recording of recording data in the external memory and reproduction based on the recording data recorded in the external memory,
the digital recording and reproducing apparatus comprising:
an identification data-generating block for generating identification data for identifying the external memory individually;
an internal memory in which the identification data can be recorded; and
a control block for recording the identification data in the external memory and said internal memory, and carrying out identification data determination processing for determining, when mounting of the external memory is detected, whether or not the identification data recorded in the external memory and the identification data recorded in said internal memory are identical to each other.

2. A digital recording and reproducing apparatus according to claim 1, wherein said control block records the identification data in both of the external memory and said internal memory before the recording data is recorded in the external memory.

3. A digital recording and reproducing apparatus according to claim 2, wherein said control block carries out the identification data determination processing when the external memory is removed and mounted during recording of the recording data in the external memory, said control block continuing to record the recording data in the mounted external memory when the identification data recorded in the external memory and the identification data recorded in said internal memory are identical to each other, and carrying out predetermined error-handling processing when the identification data recorded in the external memory and the identification data recorded in said internal memory are different from each other.

4. A digital recording and reproducing apparatus according to claim 2, wherein said control block causes the recording data to be recorded in said internal memory when the external memory is removed during recording of the recording data in the external memory, carries out the identification data determination processing when the external memory is mounted, and records the recording data recorded in said internal memory, in the mounted external memory when the identification data recorded in the external memory and the identification data recorded in said internal memory are identical to each other.

5. A digital recording and reproducing apparatus according to any one of claims 1 to 4, wherein said identification data-generating block generates numerical value information at random to thereby generate the identification data.

6. A digital recording and reproducing apparatus according to claim any one of claims 1 to 4, wherein the recording data is sound data, and wherein the digital recording and reproducing apparatus includes a sound signal input block for inputting an analog sound signal, a sound data generation block for generating the sound data by converting the analog sound signal to digital data and compressing the digital data, a sound signal generation block for decompressing the sound data recorded in the external memory to generate the digital data and converting the digital data to the analog sound signal, and an amplifier circuit for amplifying the converted analog sound signal to output the amplified sound signal.

7. A digital recording and reproducing apparatus according to claim 5, wherein the recording data is sound data, and wherein the digital recording and reproducing apparatus includes a sound signal input block for inputting an analog sound signal, a sound data generation block for generating the sound data by converting the analog sound signal to digital data and compressing the digital data, a sound signal generation block for decompressing the sound data recorded in the external memory to generate the digital data and converting the digital data to the analog sound signal, and an amplifier circuit for amplifying the converted analog sound signal to output the amplified sound signal.
